Europäisches Patentamt

European Patent Office

Office européen des brevets

(11) Publication number: **0 025 303**
**B1**

(12) **EUROPEAN PATENT SPECIFICATION**

(45) Date of publication of patent specification: **19.06.85**

(51) Int. Cl.⁴: **G 11 C 7/00, G 11 C 11/40**

(21) Application number: **80302916.4**

(22) Date of filing: **22.08.80**

(54) **Read current detector circuit for semiconductor memory.**

(30) Priority: **23.08.79 JP 107394/79**

(43) Date of publication of application:
**18.03.81 Bulletin 81/11**

(45) Publication of the grant of the patent:
**19.06.85 Bulletin 85/25**

(84) Designated Contracting States:
**DE FR GB NL**

(56) References cited:
**IBM TECHNICAL DISCLOSURE BULLETIN,
volume 19, no. 11, April 1977 NEW YORK (US)
E.C. JACOBSON "Word-line failure detection
circuit", pages 4197-4198
IEEE JOURNAL OF SOLID-STATE CIRCUITS,
volume SC-13, no. 5, October 1978 NEW YORK
(US) K. KAWARADA et al. "A fast 7.5 ns access
1K-bit RAM for cachememory systems" pages
656-663
IBM TECHNICAL DISCLOSURE BULLETIN,
volume 14, no. 6, November 1971 NEW YORK
(US) J.K. AYLING "Differential phase sensing
and latching detector" page 1674**

(73) Proprietor: **FUJITSU LIMITED
1015, Kamikodanaka Nakahara-ku
Kawasaki-shi Kanagawa 211 (JP)**

(72) Inventor: **Takahashi, Yukio
No. 528, Kozuhara Ibuki-cho
Sakata-gun Shiga, 521-04 (JP)**

(74) Representative: **Bedggood, Guy Stuart et al
Haseltine Lake & Co. Hazlitt House 28
Southampton Buildings Chancery Lane
London WC2A 1AT (GB)**

## Description

This invention relates to a semiconductor memory.

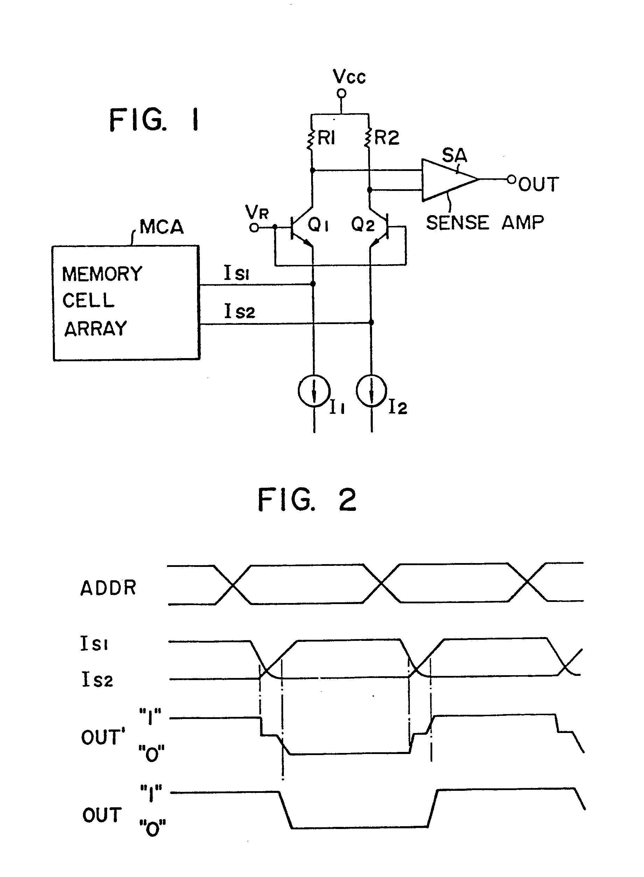

A semiconductor memory has an arrangement for detecting read-out information of the stored content of a selected memory cell. The arrangement may be as shown in Figure 1 of the accompanying drawings, which is a schematic circuit diagram of a detector circuit as employed in a conventional semiconductor memory. In Fig. 1, MCA is a memory cell array in which there are a plurality of memory cells, each formed by a bipolar transistor, SA is a sense amplifier; and R1, R2 and $Q_1$, $Q_2$ are respective resistors and transistors which make up a detector circuit. Bias currents $I_1$ and $I_2$ are always applied to the transistors $Q_1$ and $Q_2$ for high-speed operation thereof, and in accordance with the store state of a selected memory cell, one or other of read currents $Is_1$ and $Is_2$ for the memory cell array MCA is zero and the other assumes a certain value. Because of this, voltage drops across the resistors R1 and R2 differ in magnitude and the difference voltage is amplified by the sense amplifier SA to produce a read output OUT. $V_R$ is a reference voltage which is applied to the bases of the transistors $Q_1$ and $Q_2$; and Vcc is a power source voltage.

If the currents $Is_1$ and $Is_2$ are switched ideally, then the read output OUT correspondingly becomes ideal. In a transient state in the operation of a switching circuit accompanying a memory access, however, cases are sometimes met with where

$$Is_1 = Is_2 = 0 \text{ or } Is_1 = Is_2 = 1,$$

in which cases the waveform of the read output OUT is indistinct, resulting in a read error.

Figure 2 of the accompanying drawings is a timing chart for assistance in further explanation with reference to Figure 1.

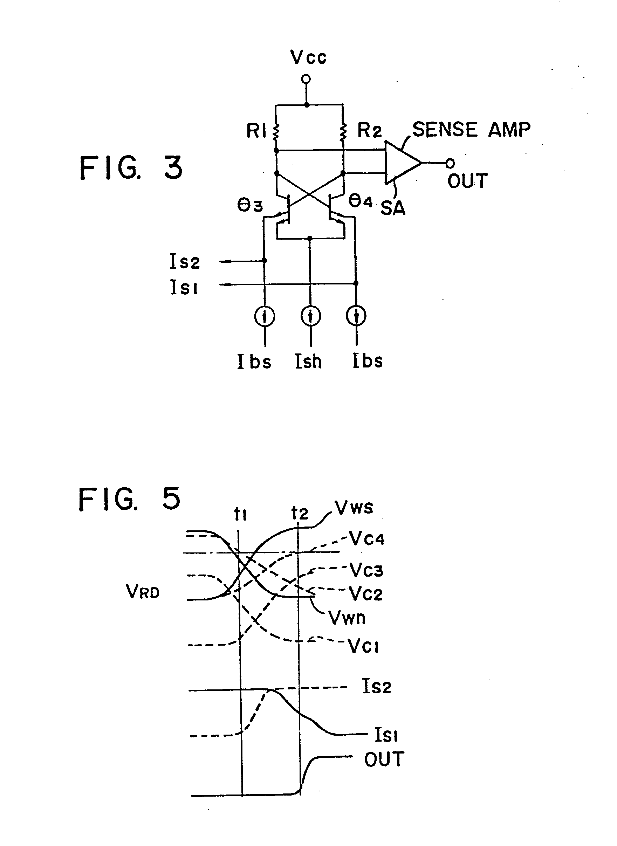

Assuming that the currents $Is_1$ and $Is_2$ vary as shown in Figure 2 each time a memory address ADDR (for accessing array MCA) is established, the output OUT' from the sense amplifier SA may sometimes assume a level intermediate between levels "1" and "0" corresponding to the characteristic of the detector circuit as shown in Fig. 1. That is, the output does not immediately reverse from the level "1" to "0" but first assumes an intermediate level and then reverses. Furthermore, when the relationship between the currents $Is_1$ and $Is_2$ is changed as a result of switching noise or the like, an output OUT level corresponding to the noise is obtained; namely, the output is affected by the noise. With increased memory cell capacity, the load on a word line increases and a hold current decreases. As a result of this, the rise and fall of the word line potential are delayed and the both detected (read) currents concurrently flow to the same amplifier SA for a certain period of time, as described above; in this case, the abovesaid intermediate level is introduced into the amplifier output from the sense amplifier SA. This phenomenon is prominent when an address includes a skew. With a view to overcoming such a defect, there has been proposed such a circuit arrangement as shown in Fig. 3 of the accompanying drawings, which is a schematic circuit diagram, in which the sense amplifier SA is a latch type amplifier.

In Fig. 3, reference character Ish indicates a hold current. In this example, the sense amplifier SA operates only when the difference between the read currents $Is_1$ and $Is_2$ becomes larger than the hold current Ish; namely, the sense amplifier SA has a hysteresis characteristic. In other words, even if the waveforms of the read currents $Is_1$ and $Is_2$ are unstable, the waveforms do not directly appear in the sense amplifier SA because of the latch operation, and consequently the output waveform is improved. In this circuit arrangement, however, the hold current Ish flows at all times and the sense amplifier SA does not start its operation unless the difference between the read currents $Is_1$ and $Is_2$ exceeds the hold current Ish; namely, circuit operation is delayed by the rise time which elapses until the abovesaid difference exceeds the hold current, resulting in the defect that the read rate is sacrificed.

In Figure 3, Ibs indicates bias currents, and $\theta_3$, $\theta_4$ are transistors.

According to the present invention there is provided a semiconductor memory having a memory cell array including a plurality of memory cells, and having a plurality of word lines and a plurality of bit lines for selecting a desired one of the memory cells, and a detector circuit, for detecting a read current of a selected memory cell of the memory cell array, said detector circuit including a pair of transistors having their bases cross-connected to provide a hysteresis characteristic which is obtained by applying a current to the transistors, wherein the detector circuit further includes a hysteresis characteristic control circuit which monitors the word line potentials and delivers a current to provide the hysteresis characteristic only when all the word line potentials have become lower than a predetermined potential.

A semiconductor memory embodying the present invention can be freer from the influence of noise produced in the detection of read-out information without undue sacrifice of read rate.

Reference is made, by way of example, to the accompanying drawings, in which:—

Fig. 1, as mentioned above, is a schematic circut diagram of a detector circuit as employed in a conventional semiconductor memory;

Fig. 2 is, as mentioned above, a timing chart for assistance in further explanation of the circuit shown in Fig. 1;

Fig. 3 as mentioned above, is a schematic circuit diagram illustrating an example of a conventional detector circuit improved as compared with the circuit of Fig. 1 but still defective;

Fig. 4 is a schematic circuit diagram showing principal parts of an embodiment of the present invention; and

Fig. 5 is a timing chart explanatory of the operation of the embodiment shown in Fig. 4.

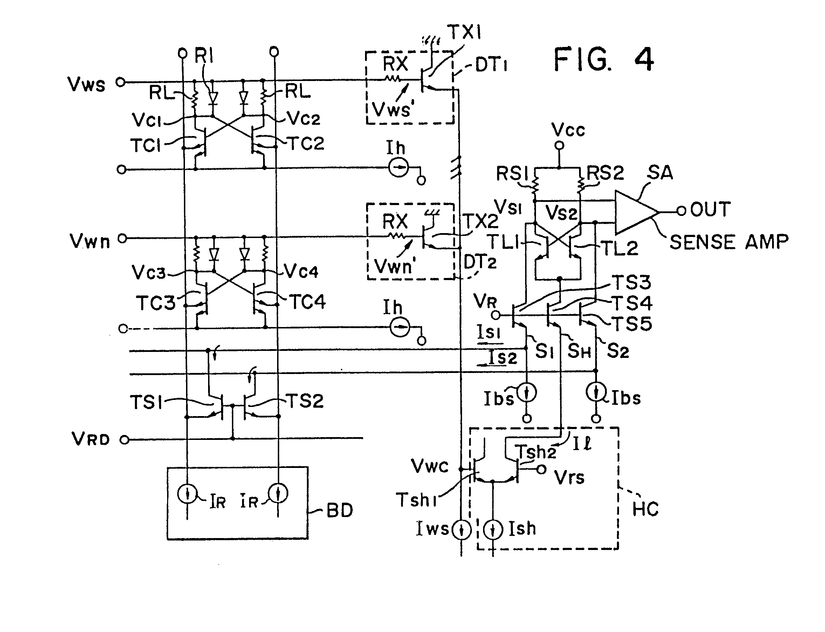

Fig. 4 illustrates an embodiment of the present invention, in which reference characters $DT_1$ and $DT_2$ indicate word line potential selection/non-selection detector circuits; HC designates a hysteresis characteristic control circuit which controls a hold current of a latch circuit added to a sense amplifier circuit and having a hysteresis characteristic; and BD identifies a bit line drive circuit which drives bit lines.

Those portions in Figure 4 which are each disposed between two bit lines (which can be seen running vertically from circuit BD), a word line (for example, Vws or Vwn) for driving a memory cell and a word line supplied with a current Ih for holding a stored content of a memory cell, are respective memory cells. The memory cells are assembled together to constitute a memory cell array.

In Fig. 4, each memory cell is for example a cell comprising two transistors (TC1, TC2 or TC3, TC4), resistors (RL) and diodes (R1). The collectors of transistors TC1, TC2 and transistors TC3, TC4 are connected to driving word lines Vws and Vwn respectively. Emitters of transistors TC1, TC2 and transistors TC3, TC4 are connected to respective word lines which receive holding currents Ih. Emitters of transistors TC1, TC3 and transistors TC2, TC4 are connected to bit line drive circuit BD via respective bit lines. Transistors TS1, TS2 are arranged for passing read currents Is1, Is2 (in relation to a selected cell) when read voltage VRD indicates a read operation. Driving word lines Vws and Vwn are connected to detector circuits DT1 and DT2 respectively. Each detector circuit includes a resistor RX and a transistor (TX1 or TX2). The outputs of the detector circuits are connected to a word line Vwc which can permit passage of a current Iws.

The potential state of a word line represented by Vwc is the logical sum of the outputs of the plurality of word line potential selection/non-selection detector circuits DT and becomes high-level whenever one or more of the detector circuits DT is high-level.

In the hysteresis characteristic control circuit HC transistor $Tsh_2$ is supplied with a predetermined reference potential Vrs and a transistor $Tsh_1$ receives the potential on word line Vwc. $Tsh_1$ and $Tsh_2$ have their emitters interconnected and compare the potential of word line Vwc with the reference potential Vrs. In other words, the transistors $Tsh_1$ and $Tsh_2$, which are supplied with current Ish, monitor the word line potential and when the word line potential Vwc has become lower than the predetermined potential Vrs, the transistor $Tsh_2$ is turned ON to permit the passage therethrough of a current I1 which provides the hysteresis characteristic for transistors TL1, TL2.

TL1 and TL2 are a pair of transistors which have their bases cross-connected (e.g. base of one connected to collector or other) and whose states are inverted by the current I1 to provide a hysteresis characteristic. That is, the ON-OFF state of the transistors TL1 and TL2 is inverted when a difference between read currents $Is_1$ and $Is_2$ exceeds a predetermined value defined by the current I1.

Now, let it be assumed that transistors TC1 and TC4 are in the ON state in Fig. 4 and that a word line Vwn is selected first and then a word line Vws. When the potential of the word line Vwn changes from its high level to low level and the potential of the word line Vws changes from its low level to high level, potentials $Vc_1$ to $Vc_4$ and the currents $Is_1$ to $Is_2$ vary as shown in Fig. 5. With increased memory cell capacity, load on a word line increases and cell load resistance R increases. Accordingly, as will be seen from Fig. 4, the collector potential of the cell on the side of the transistor in the ON state rapidly follows up the word line potential because of low impedance, but the collector potential on the side of the transistor in the OFF state appreciably lags the word line potential because of high impedance. In the course of this transition, that is, in an address undecided region, transistors are turned ON at the same time and the two input potentials of the sense amplifier circuit become equal to each other, introducing an intermediate level in the course of transition, as will be described in detail later on.

In the present invention, the word line potentials are detected by resistors RX and transistors TX1, TX2 in the word selection/non-selection detector circuits DT and the emitters of the transistors TX1, TX2 are connected in common, whereby the highest potential is always provided on the work line Vwc. Since this potential drops when an address is changed over, it is compared with the reference voltage Vrs and the current I1 is applied to the pair of transistors TL1 and TL2 in the stage preceding sense amplifier circuit SA for a predetermined period of time (the transistors $Tsh_1$ and $Tsh_2$ making up a current switch). The time for which a current Ish (and consequently the current I1) is applied is determined by suitably setting up the resistance value of resistors RX and the reference voltage Vrs.

Transistors TS3, TS4 and TS5 are provided for cutting off capacitances parasitic on lines $S_1$, $S_2$ and $S_H$ to enable a high-speed operation. Voltage $V_R$ is applied to bases of transistors $S_1$, $S_2$, $S_H$ and current Ibs is applied to each of the transistors TS3 and TS5 to hold it in the ON state at all times for speeding up its operation.

Vcc is a power source voltage and RS1 and RS2 are resistors of value RS.

When the word line is switched, the current $Is_1/Is_2$ causes a current $I_R$ to flow in the both bit lines; and if the hold current I1 did not exist, then

$$Vs_1 = Vs_2 = Vcc - RS \ (I_R + Ibs)$$

and $Vs_1$ and $Vs_2$ (the collector potentials of TS1, TS2) become equipotential, resulting in the output assuming an intermediate level. In the circuit of the present invention, however, the current I1 (Ish) flows in line $S_H$ when the word line is changed over, and since the current I1 flows via the transistor TL1 then when the potential $Vs_1$ is, for example, low-level and the potential $Vs_2$ is, for example, high-level,

$$Vs_1 = Vcc - Rs \ (I1 + I_R + Ibs)$$
and
$$Vs_2 = Vcc - RS \ (I_R + Ibs),$$

holding the potential $Vs_1$ low-level and the potential $Vs_2$ high-level. When the word line potential Vws becomes high-level, the current I1 becomes zero, the current $Is_1$ becomes zero and the current $Is_2$ becomes equal to the current $I_R$. Consequently,

$$Vs_1 = Vcc - RSIbs$$
and
$$Vs_2 = Vcc - RS \ (Ibs + I_R);$$

namely, the potential $Vs_1$ becomes high-level and the potential $Vs_2$ low-level. Accordingly, in an embodiment of the present invention, in an address undecided region in which address is changed over, the hysteresis characteristic acts to hold the pair of transistors TL1 and TL2 in their previous state, preventing equal potentials from being applied to the sense amplifier circuit SA. Moreover, since the hysteresis characteristic is removed when the address has once been decided, the state can be changed rapidly without being affected by the hysteresis characteristic.

As has been described in the foregoing, in an embodiment of the present invention, the possibility of a detected output assuming an intermediate level can be eliminated and a high-speed operation is made possible. Therefore, the output from the device, that is, an input signal to a following logical circuit becomes highly reliable, thus preventing erroneous operation of the logical circuit and avoiding overheads such as the provision of an extra noise margin.

Thus, in a semiconductor memory embodying this invention, which is provided with a memory cell array, word lines and bit lines for selecting a desired one of memory cells of the memory cell array and a detector circuit for detecting a read current of the selected memory cell, the detector circuit is composed of a pair of transistors having their bases cross-connected so that a hysteresis characteristic is provided by flowing a current in the transistors, and the current is controlled by a hysteresis control circuit to flow only when all word line potentials monitored by the hysteresis control circuit have become lower than a predetermined value, whereby to remove the influence of a noise in the detection of read information of the selected memory cell.

## Claims

1. A semiconductor memory having a memory cell array including a plurality of memory cells (e.g. TC1, TC2, RL, R1; TC3, TC4, etc.), and having a plurality of word lines (Vws, Vwn) and a plurality of bit lines for selecting a desired one of the memory cells, and a detector circuit (SA, RS1, RS2, TL1, TL2, HC), for detecting a read current $(Is_1, Is_2)$ of a selected memory cell of the memory cell array, said detector circuit including a pair of transistors (TL1, TL2) having their bases cross-connected to provide a hysteresis characteristic which is obtained by applying a current (I1) to the transistors, characterised in that the detector circuit further includes a hysteresis characteristic control circuit (HC) which monitors the potentials of the plurality of word lines (Vws, Vwn) and delivers a current (I1) for providing the hysteresis characteristic only when the potentials of all the word lines of the plurality have become lower than a predetermined potential $(V_{rs})$.

2. A memory as claimed in claim 1, wherein the hysteresis control circuit (HC) monitors the potentials of the word lines by comparing the potential state of a line on which the logical sum $(V_{wc})$ of the potentials of the word lines is provided with the predetermined potential $(V_{rs})$.

3. A memory as claimed in claim 2, wherein the said logical sum $(V_{wc})$ is provided through the connection of the outputs of a plurality of word line potential selection/non-selection detection circuits (DT1, DT2) in common to the said line on which the logical sum is provided, inputs of respective such word line potential selection/non-selection detection circuits being connected to respective word lines.

4. A memory as claimed in any preceding claim, wherein the respective collectors of the respective transistors of the pair (TL1, TL2) are connected to respective read current $(Is_1, Is_2)$ lines via respective further transistors (TS3, TS5), for cutting off parasitic capacitances, which are supplied with bias current $(I_{bs})$ to hold them ON at all times.

5. A memory as claimed in claim 4, wherein the said current (I1) for providing the hysteresis characteristic is supplied to the transistors (TL1, TL2) of the pair via an additional transistor (TS4), for cutting off parasitic capacitances.

## Revendications

1. Mémoire à semiconducteurs possédant un ensemble de cellules de mémoire comportant plusieurs cellules de mémoire (par exemple TC1, TC2, RL, R1; TC3, TC4, etc.) et possédant plusieurs lignes de mot (Vws, Vwn) et plusieurs lignes de bit servant à sélectionner une cellule voulue parmi les cellules de mémoire, et un circuit détecteur (SA, RS1, RS2, TL1, TL2, HC) servant à détecter le courant de lecture $(Is_1, Is_2)$ d'une cellule de mémoire sélectionnée de l'ensemble de la cellule de mémoire, ledit circuit détecteur comportant une paire de transistors (TL1, TL2) dont les bases sont détectées en croix de façon à produire une caractéristique d'hystérésis qui est obtenue par application d'un courant (I1) aux

transistors, caractérisée en ce que le circuit détecteur comporte en outre un circuit (HC) de commande de la caractéristique d'hystérésis qui contrôle les potentiels des lignes de mot (Vws, Vwn) et délivre un courant (I1) de manière que la caractéristique d'hystérésis ne soit produite que lorsque les potentiels de toutes les lignes de mot sont devenus inférieurs à un potentiel prédéterminé (Vrs).

2. Mémoire selon la revendication 1, où le circuit de commande d'hystérésis (HC) contrôle les potentiels des lignes de mot en comparant avec le potentiel prédéterminé (Vrs) l'état de potentiel d'une ligne sur laquelle la somme logique (Vwc) des potentiels des lignes de mot est produite.

3. Mémoire selon la revendication 2, où ladite somme logique (Vwc) est produite par l'intermédiaire de la connexion des sorties de plusieurs circuits détecteurs (DT1, DT2) de sélection/non-sélection de potentiel de ligne de mot en commun avec ladite ligne sur laquelle la somme logique est produite, les entrées de ces circuits détecteurs de sélection/non-sélection de potentiel de ligne de mot étant respectivement connectées aux lignes de mot.

4. Mémoire selon l'une quelconque des revendications précédentes, où les collecteurs respectifs des transistors respectifs de la paire (TL1, TL2) sont connectés à des lignes de courants de lecture (Is$_1$, Is$_2$) respectives par l'intermédiaire respectif d'autres transistors (TS3, TS5), servant à couper les capacités parasites, >lesquels reçoivent un courant de polarisation (Ibs) servant à les maintenir conducteurs à tout instant.

5. Mémoire selon la revendication 4, où ledit courant (I1) servant à produire la caractéristique d'hystérésis est délivré au transistors (TL1, TL2) de la paire par l'intermédiaire d'un transistor supplémentaire (TS4), servant à couper les capacités parasites.

**Patentansprüche**

1. Halbleiterspeicher mit einer Speicherzellenanordnung, die eine Vielzahl von Speicherzellen (z.B. TC1, TC2, RL, R1; TC3, TC4, etc.), eine Vielzahl von Wortleitungen (Vws, Vwn) und eine Vielzahl von Bitleitungen zur Auswahl einer gewünschten Speicherzelle umfaßt, und mit einer Detektorschaltung (SA, RS1, RS2, TL1, TL2, HC), zum Erfassen eines Lesestroms (Is$_1$, Is$_2$) einer ausgewählten Speicherzelle der Speicherzelleanordnung, die ein Paar von Transistoren (TL1, TL2) umfaßt, deren Basen kreuzweise angeschlossen sind, um eine Hysteresis-Charakteristik zu bilden, welche durch Zuführung eines Stromes (I1) zu den Transistoren erzielt wird, dadurch gekennzeichnet, daß die Detektorschaltung ferner eine Hysteresis-Charakteristik-Steuerschaltung (HC) umfaßt, welche das Potential der Vielzahl von Wortleitungen (Vws, Vwn) überwacht und einen Strom (I1) zur Erzeugung der Hysteresis-Charakteristik nur dann liefert, wenn das Potential aller Wortleitungen der Vielzahl geringer als ein vorbestimmtes Potential (V$_{rs}$) geworden ist.

2. Speicher nach Anspruch 1, bei welchem die Hysteresis-Steuerschaltung (HC) die Potentiale der Wortleitungen durch Vergleich des Potentialzustands einer Leitung, auf welcher die logische Summe (V$_{wc}$) des Potentials der Wortleitungen vorgesehen ist, mit einem vorbestimmten Potential (V$_{rs}$) überwacht.

3. Speicher nach Anspruch 2, bei welchem die genannte Summe (V$_{wc}$) über die Verbindung der Ausgänge einer Vielzahl von Detektorschaltungen (DT1, DT2) des Auswahl/Nichtauswahlpotentials der Wortleitungen vorgesehen wird, die der genannten Leitung, auf welcher die logische Summe vorgesehen ist, gemeinsam sind, wobei Eingänge von solchen entsprechenden Wortleitungs-Potentialauswahl/-nichtauswahl-Detektorschaltungen mit den entsprechenden Wortleitungen verbunden sind.

4. Speicher nach einem der vorhergehenden Ansprüche, bei welchem entsprechende Kollektoren der jeweiligen Transistoren der Paares (TL1, TL2) mit entsprechenden Lesestromleitungen (Is$_1$, Is$_2$) über entsprechende weitere Transistoren (TS3, TS5) zum Abschneiden parasitärer Kapazitäten verbunden sind, denen ein Vorspannungsstrom (I$_{bs}$) zugeführt wird, um sie jederzeit in dem Zustand "EIN" zu halten.

5. Speicher nach Anspruch 4, bei welchem der genannte Strom (I1) zur Lieferung der Hysteresis-Charakteristik den Transistoren (TL1, TL2) des Paars über einen zusätzlichen Transistor (TS4) zum Abschneiden parasitärer Kapazitäten zugeführt wird.

FIG. 1

FIG. 2

FIG. 3

FIG. 5

FIG. 4